# EUROPEAN PATENT APPLICATION

(11) **EP 4 178 329 A1**
(43) Date of publication of application: **10.05.2023**
(21) Application number: 22203157.7
(22) Date of filing: 21.10.2022
(51) Int. Cl.: H10K 59/122, H10K 59/124, H10K 59/80, H10K 59/35

(54) **DISPLAY DEVICE**

(30) Priority: 03.11.2021 KR 20210150054
(71) Applicant: LG Display Co., Ltd., SEOUL, 07336 (KR)
(72) Inventor: LEE, Seongjoo, 10845 Paju-Si (KR); BAEK, JungSun, 10845 Paju-si (KR); SONG, ChangHyun, 10845 Paju-si (KR); HONG, Seungpyo, 10845 Paju-si (KR)
(74) Representative: Bryn-Jacobsen, Caelia

(57) **Abstract**

A display device includes: a substrate including a plurality of sub-pixels; an overcoating layer on the substrate and including a base portion and a protruding portion; a first electrode covering the base portion and the protruding portion; a bank on a part of the first electrode; an organic layer on the first electrode and the bank; and a second electrode on the organic layer, in which a distance between a side surface of the protruding portion and a side surface of the bank varies for each of the plurality of sub-pixels.

## Description

### CROSS-REFERENCE TO RELATED APPLICATIONS

This application claims the priority of Korean Patent Application No. 10-2021-0150054 filed on November 3, 2021, in the Korean Intellectual Property Office.

### BACKGROUND

### Field

The present disclosure relates to a display device, and more particularly, to a display device capable of improving a brightness viewing angle and a color viewing angle.

### Description of the Related Art

Recently, display devices, which visually display electrical information signals, are being rapidly developed in accordance with the full-fledged entry into the information era. Various studies are being continuously conducted to develop a variety of display devices which are thin and lightweight, consume low power, and have improved performance.

Among the various display devices, a light-emitting display device refers to a display device that autonomously emits light. Unlike a liquid crystal display device, the light-emitting display device does not require a separate light source and thus may be manufactured as a lightweight, thin display device. In addition, the light-emitting display device is advantageous in terms of power consumption because the light-emitting display device operates at a low voltage. Further, the light-emitting display device is expected to be adopted in various fields because the light-emitting display device is also excellent in implementation of colors, response speeds, viewing angles, and contrast ratios (CRs).

### SUMMARY

An object to be achieved by the present disclosure is to provide a display device capable of improving luminous efficiency of an organic light-emitting element and power consumption by using an anode having a side mirror shape.

Another object to be achieved by the present disclosure is to provide a display device capable of improving a brightness viewing angle and a color viewing angle by setting a distance between a side surface of an overcoating layer and a side surface of a bank so that the distance varies for each sub-pixel.

Objects of the present disclosure are not limited to the above-mentioned objects, and other objects, which are not mentioned above, can be clearly understood by those skilled in the art from the following descriptions.

According to an aspect of the present disclosure, a display device includes: a substrate including a plurality of sub-pixels; an overcoating layer on the substrate and including a base portion and a protruding portion; a first electrode covering the base portion and the protruding portion; a bank on a part of the first electrode; an organic layer on the first electrode and the bank; and a second electrode on the organic layer, in which a distance between a side surface of the protruding portion and a side surface of the bank varies for each of the plurality of sub-pixels.

According to another aspect of the present disclosure, a display device includes: a substrate including a plurality of sub-pixels; an overcoating layer on the substrate and including a base portion and a protruding portion; a first electrode covering the base portion and the protruding portion; a bank on a part of the first electrode; an organic layer on the first electrode and the bank; and a second electrode on the organic layer, in which a width of the bank corresponding to a side surface of the protruding portion varies for each of the plurality of sub-pixels.

According to yet another aspect of the present disclosure, a display device includes: a substrate including a plurality of sub-pixels; an overcoating layer on the substrate and having a concave portion; a first electrode covering the concave portion; a bank configured to expose a part of the first electrode through an opening; an organic layer on the first electrode; and a second electrode on the organic layer, in which each of at least two sub-pixels, among the plurality of sub-pixels, have different values that are made by subtracting a width of the opening from a width of the concave portion.

According to yet another aspect of the present disclosure, a display device includes : an overcoating layer on a substrate; and a plurality of light emitting elements disposed on the overcoating layer, each of the light emitting elements including a first electrode, an organic layer on the first electrode, and a second electrode on the organic layer, in which the first electrode includes a first portion, a second portion that is on a first side of the first portion and inclined with respect to the first portion, and a third portion that is on a second side of the first portion and inclined with respect to the first portion; in which the organic layer includes a first part, a second part that is on a first side of the first part and inclined with respect to the first part, and a third part that is on a second side of the first part and inclined with respect to the first part, the first part of the organic layer having a smaller width than the first portion of the first electrode by a distance that is different among the plurality of light emitting elements; and in which the second electrode includes a first section, a second section that is on a first side of the first section and inclined with respect to the first section, and a third section that is on a second side of the first section and inclined with respect to the first section.

Other detailed matters of the exemplary examples are included in the detailed description and the drawings.

The present disclosure may improve light extraction efficiency of the display device by using the anode having a side mirror shape.

The present disclosure may improve the brightness viewing angle and the color viewing angle by adjusting the width of the bank, which corresponds to the side surface of the protruding portion of the overcoating layer, for each of the sub-pixels.

The effects according to the present disclosure are not limited to the contents exemplified above, and more various effects are included in the present specification.

### BRIEF DESCRIPTION OF THE DRAWINGS

The above and other aspects, features and other advantages of the present disclosure will be more clearly understood from the following detailed description taken in conjunction with the accompanying drawings, in which:
FIG. 1 is a top plan view of a display device according to an exemplary example of the present disclosure;
FIG. 2 is a cross-sectional view of the display device taken along line II-II' in FIG. 1;
FIG. 3 is a cross-sectional view of the display device taken along line III-III' in FIG. 1;
FIG. 4 is a schematic top plan view of FIG. 3;
FIG. 5 is a graph illustrating a change in brightness with respect to a viewing angle;
FIG. 6 is a cross-sectional view of a display device according to another exemplary example of the present disclosure;
FIG. 7 is a graph illustrating a change in brightness with respect to a viewing angle; and
FIG. 8 is a graph illustrating a color shift with respect to a viewing angle.

### DETAILED DESCRIPTION OF THE EXAMPLE

Advantages and characteristics of the present disclosure and a method of achieving the advantages and characteristics will be clear by referring to exemplary examples described below in detail together with the accompanying drawings. However, the present disclosure is not limited to the exemplary examples disclosed herein but will be implemented in various forms. The exemplary examples are provided by way of example only so that those skilled in the art can fully understand the disclosures of the present disclosure and the scope of the present disclosure.

The shapes, sizes, ratios, angles, numbers, and the like illustrated in the accompanying drawings for describing the exemplary examples of the present disclosure are merely examples, and the present disclosure is not limited thereto. Like reference numerals generally denote like elements throughout the specification. Further, in the following description of the present disclosure, a detailed explanation of known related technologies may be omitted to avoid unnecessarily obscuring the subject matter of the present disclosure. The terms such as "including," "having," and "consist of" used herein are generally intended to allow other components to be added unless the terms are used with the term "only". Any references to singular may include plural unless expressly stated otherwise.

Components are interpreted to include an ordinary error range even if not expressly stated.

When the position relation between two parts is described using the terms such as "on", "above", "below", and "next", one or more parts may be positioned between the two parts unless the terms are used with the term "immediately" or "directly".

When an element or layer is disposed "on" another element or layer, another layer or another element may be interposed directly on the other element or therebetween.

Although the terms "first", "second", and the like are used for describing various components, these components are not confined by these terms. These terms are merely used for distinguishing one component from the other components. Therefore, a first component to be mentioned below may be a second component in a technical concept of the present disclosure.

Like reference numerals generally denote like elements throughout the specification.

A size and a thickness of each component illustrated in the drawing are illustrated for convenience of description, and the present disclosure is not limited to the size and the thickness of the component illustrated.

The features of various examples of the present disclosure can be partially or entirely adhered to or combined with each other and can be interlocked and operated in technically various ways, and the examples can be carried out independently of or in association with each other.

Hereinafter, the present disclosure will be described in detail with reference to accompanying drawings.

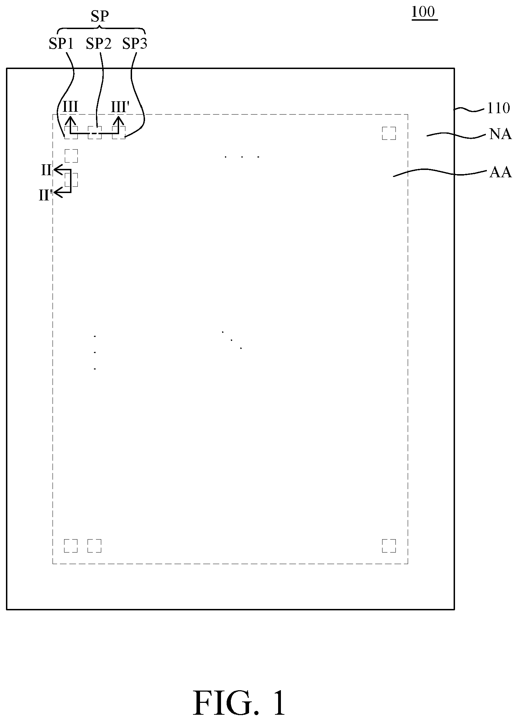

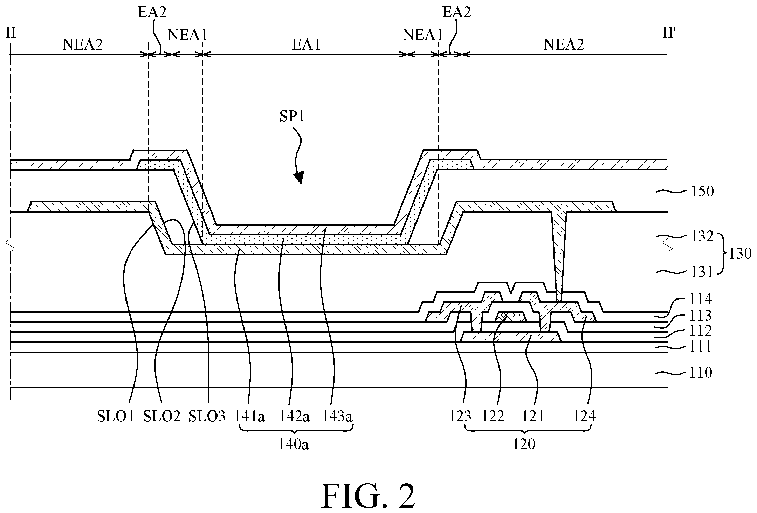

FIG. 1 is a top plan view of a display device according to an exemplary example of the present disclosure. FIG. 2 is a cross-sectional view of the display device taken along line II-II' in FIG. 1.

Referring to FIGS. 1 and 2, the display device 100 includes a substrate 110, a transistor 120, an overcoating layer 130, a first light-emitting element 140a, and a bank 150. The display device 100 may be implemented as a top-emission type display device, but the present disclosure is not limited thereto.

The substrate 110 is a substrate configured to support and protect several constituent elements of the display device 100. The substrate 110 may be made of glass or a plastic material having flexibility. In the case in which the substrate 110 is made of a plastic material, the substrate 110 may be made of polyimide (PI), for example. However, the present disclosure is not limited thereto.

The substrate 110 includes a display area AA and a non-display area NA.

The display area AA refers to an area of the display device 100 in which images are displayed. Various display elements and various driving elements for operating the display elements may be disposed in the display area AA. For example, the display elements may include a first light-emitting element 140a including a first electrode 141a, an organic layer 142a, and a second electrode 143a. In addition, various driving elements such as a transistor 120, a capacitor, lines, and the like, which are configured to operate the display elements, may be disposed in the display area AA.

A plurality of sub-pixels SP may be included in the display area AA. The sub-pixel SP is a minimum unit that constitutes a screen. Each of the plurality of sub-pixels SP may include a display element and a drive circuit. The plurality of sub-pixels SP may emit light beams having different wavelengths. For example, the plurality of sub-pixels SP may include a first sub-pixel SP1 configured to emit red light, a second sub-pixel SP2 configured to emit green light, and a third sub-pixel SP3 configured to emit blue light. The first sub-pixel SP1, the second sub-pixel SP2, and the third sub-pixel SP3 may be sequentially arranged in the display area AA. However, the present disclosure is not limited thereto. In addition, FIG. 1 illustrates that the first sub-pixel SP1, the second sub-pixel SP2, and the third sub-pixel SP3 have the same area. However, the present disclosure is not limited thereto. That is, the first sub-pixel SP1, the second sub-pixel SP2, and the third sub-pixel SP3 may have different areas. In addition, FIG. 1 illustrates that each of the first sub-pixel SP1, the second sub-pixel SP2, and the third sub-pixel SP3 have a square shape. However, the present disclosure is not limited thereto. That is, each of the first sub-pixel SP1, the second sub-pixel SP2, and the third sub-pixel SP3 may have a circular shape, a polygonal shape, or the like.

The drive circuit of the sub-pixel SP is a circuit for controlling an operation of the display element. For example, the drive circuit may include driving elements such as the transistor 120 and the capacitor. However, the present disclosure is not limited thereto.

The non-display area NA refers to an area in which no image is displayed. Various constituent elements for operating the plurality of sub-pixels SP disposed in the display area AA may be disposed in the non-display area NA. For example, drive ICs, flexible films, and the like, which are configured to supply signals for operating the plurality of sub-pixels SP, may also be disposed.

As illustrated in FIG. 1, the non-display area NA may be an area that surrounds the display area AA. However, the present disclosure is not limited thereto. For example, the non-display area NA may be an area extending from the display area AA.

Hereinafter, the first sub-pixel SP1 of the plurality of sub-pixels SP disposed in the display area AA will be described in more detail with reference to FIG. 2.

A buffer layer 111 is disposed on the substrate 110. The buffer layer 111 may serve to increase bonding forces between the substrate 110 and layers formed on the buffer layer 111 and block a leak of an alkaline material from the substrate 110. The buffer layer 111 may be configured as a single layer made of silicon nitride (SiNx) or silicon oxide (SiOx) that is an inorganic material. Alternatively, the buffer layer 111 may be configured as a multilayer made of silicon nitride (SiNx) or silicon oxide (SiOx). However, the present disclosure is not limited thereto. The buffer layer 111 is not an essential constituent element. The buffer layer 111 may be omitted depending on the type and material of the substrate 110, the structure and type of the transistor 120, and the like.

The transistor 120 is disposed on the buffer layer 111. The transistor 120 may be used as a driving element for operating the first light-emitting element 140a in the display area AA. The transistor 120 includes an active layer 121, a gate electrode 122, a source electrode 123, and a drain electrode 124. The transistor 120 illustrated in FIG. 2 is a driving transistor. The transistor 120 is a thin-film transistor having a top-gate structure in which the gate electrode 122 is disposed on the active layer 121. However, the present disclosure is not limited thereto. The transistor 120 may be implemented as a transistor having a bottom-gate structure.

The active layer 121 is disposed on the buffer layer 111. The active layer 121 is an area in which a channel is formed when the transistor 120 operates. The active layer 121 may be made of an oxide semiconductor. The active layer 121 may be made of amorphous silicon (a-Si), polycrystalline silicon (poly-Si), an organic semiconductor, or the like.

A gate insulating layer 112 is disposed on the active layer 121. The gate insulating layer 112 is a layer for electrically insulating the active layer 121 and the gate electrode 122. The gate insulating layer 112 may be made of an insulating material. For example, the gate insulating layer 112 may be configured as a single layer made of silicon nitride (SiNx) or silicon oxide (SiOx) that is an inorganic material. Alternatively, the gate insulating layer 112 may be configured as a multilayer made of silicon nitride (SiNx) or silicon oxide (SiOx). However, the present disclosure is not limited thereto.

The gate insulating layer 112 has contact holes through which the source electrode 123 and the drain electrode 124 are in contact with a source area and a drain area of the active layer 121, respectively. As illustrated in FIG. 2, the gate insulating layer 112 may be formed over the entire surface of the substrate 110 or patterned to have the same width as the gate electrode 122. However, the present disclosure is not limited thereto.

The gate electrode 122 is disposed on the gate insulating layer 112. The gate electrode 122 is disposed on the gate insulating layer 112 and overlaps the channel area of the active layer 121. The gate electrode 122 may be made of any one of various metallic materials, for example, molybdenum (Mo), aluminum (Al), chromium (Cr), gold (Au), titanium (Ti), nickel (Ni), neodymium (Nd), copper (Cu), and an alloy of two or more of these metallic materials. Alternatively, the gate electrode 122 may be configured as a multilayer made of various metallic materials, for example, molybdenum (Mo), aluminum (Al), chromium (Cr), gold (Au), titanium (Ti), nickel (Ni), neodymium (Nd), copper (Cu), and an alloy of two or more of these metallic materials. However, the present disclosure is not limited thereto.

An interlayer insulating layer 113 is disposed on the gate electrode 122. The interlayer insulating layer 113 may be configured as a single layer made of silicon nitride (SiNx) or silicon oxide (SiOx) that is an inorganic material. Alternatively, the interlayer insulating layer 113 may be configured as a multilayer made of silicon nitride (SiNx) or silicon oxide (SiOx). However, the present disclosure is not limited thereto. The interlayer insulating layer 113 has contact holes through which the source electrode 123 and the drain electrode 124 are in contact with the source area and the drain area of the active layer 121, respectively.

The source electrode 123 and the drain electrode 124 are disposed on the interlayer insulating layer 113. The source electrode 123 and the drain electrode 124 are disposed on the same layer and spaced apart from each other. The source electrode 123 and the drain electrode 124 are electrically connected to the active layer 121 through the contact holes of the gate insulating layer 112 and the contact holes of the interlayer insulating layer 113. Each of the source electrode 123 and the drain electrode 124 may be made of any one of various metallic materials, for example, molybdenum (Mo), aluminum (Al), chromium (Cr), gold (Au), titanium (Ti), nickel (Ni), neodymium (Nd), copper (Cu), and an alloy of two or more of these metallic materials. Alternatively, each of the source electrode 123 and the drain electrode 124 may be configured as a multilayer made of various metallic materials, for example, molybdenum (Mo), aluminum (Al), chromium (Cr), gold (Au), titanium (Ti), nickel (Ni), neodymium (Nd), copper (Cu), and an alloy of two or more of these metallic materials. However, the present disclosure is not limited thereto.

FIG. 2 illustrates only the driving transistor among various transistors 120 included in the display device 100. However, the other transistors such as a switching transistor may be disposed.

A passivation layer 114 is disposed on the source electrode 123 and the drain electrode 124. The passivation layer 114 may cover the transistor 120 and electrically insulate and protect the transistor 120 and the other constituent elements. The passivation layer 114 has a contact hole through which the drain electrode 124 of the transistor 120 is exposed. FIG. 2 illustrates that the contact hole is formed in the passivation layer 114 in order to expose the drain electrode 124. However, the present disclosure is not limited thereto. For example, the passivation layer 114 may have a contact hole through which the source electrode 123 is exposed. The passivation layer 114 may be configured as a single layer made of silicon nitride (SiNx) or silicon oxide (SiOx) that is an inorganic material. Alternatively, the passivation layer 114 may be configured as a multilayer made of silicon nitride (SiNx) or silicon oxide (SiOx). However, the present disclosure is not limited thereto.

The overcoating layer 130 is disposed on the passivation layer 114. The overcoating layer 130 is an insulating layer that serves to protect the transistor 120 and flatten an upper portion of the transistor 120. The overcoating layer 130 has a contact hole through which the drain electrode 124 of the transistor 120 is exposed. FIG. 2 illustrates that the contact hole is formed in the overcoating layer 130 in order to expose the drain electrode 124. However, the present disclosure is not limited thereto. For example, the overcoating layer 130 may have a contact hole through which the source electrode 123 is exposed. The overcoating layer 130 may be made of any one of acrylic resin, epoxy resin, phenolic resin, polyamide-based resin, polyimide-based resin, unsaturated polyester-based resin, polyphenylene-based resin, polyphenylene sulfide-based resin, benzocyclobutene, and photoresist. However, the present disclosure is not limited thereto.

The overcoating layer 130 may include a base portion 131 and a plurality of protruding portions 132. As illustrated in FIG. 2, the base portion 131 and the plurality of protruding portions 132 may be integrated. For example, the base portion 131 and the plurality of protruding portions 132 may be made of the same material and formed through the same process, for example, the same mask process. However, the present disclosure is not limited thereto.

The base portion 131 is disposed on the passivation layer 114. A top surface of the base portion 131 has a surface parallel to the substrate 110. Therefore, the base portion 131 may eliminate a level difference that may occur because of a constituent element disposed on a lower portion of the base portion 131.

The plurality of protruding portions 132 is disposed on the base portion 131. The plurality of protruding portions 132 is integrated with the base portion 131 and each has a shape protruding from the base portion 131. Each of the plurality of protruding portions 132 may have a shape having a top surface smaller than a bottom surface. However, the present disclosure is not limited thereto.

Each of the plurality of protruding portions 132 may have a top surface and a side surface. The top surface of the protruding portion 132 is a surface positioned at an uppermost side of the protruding portion 132. The top surface of the protruding portion 132 may be a surface substantially parallel to the base portion 131 or the substrate 110. The side surface of the protruding portion 132 may be a first inclined surface SLO1 that connects the top surface of the protruding portion 132 and the base portion 131. The first inclined surface SLO1 may have a shape inclined in a direction from the top surface toward the base portion 131.

Meanwhile, a region of the overcoating layer 130, in which the top surface of the base portion 131 is exposed by the plurality of protruding portions 132, may be defined as an opening. In addition, the opening of the overcoating layer 130 may be defined as a concave portion. That is, the opening of the overcoating layer 130 may be defined by the top surface of the base portion 131 and the first inclined surface SLO1 of the protruding portion 132, such that the opening may have a concave shape.

The first light-emitting element 140a is disposed on the overcoating layer 130. The first light-emitting element 140a includes the first electrode 141a electrically connected to the drain electrode 124 of the transistor 120, the organic layer 142a disposed on the first electrode 141a, and the second electrode 143a formed on the organic layer 142a. In this case, the first light-emitting element 140a may be a red light-emitting element that emits red light.

The first electrode 141a is disposed in the concave portion of the overcoating layer 130 and corresponds to each of the plurality of sub-pixels SP. The first electrode 141a is disposed to cover the base portion 131 and the plurality of protruding portions 132. Specifically, the first electrode 141a may be disposed on the top surface of the base portion 131, on which the protruding portion 132 is not disposed, and the side surfaces of the plurality of protruding portions 132. That is, the first electrode 141a is disposed along a shape of the base portion 131 and a shape of the protruding portion 132. Therefore, the first electrode 141a may include a second inclined surface SLO2 corresponding to the first inclined surface SLO1. In addition, the first electrode 141a may also be formed in a partial region of the top surface of each of the plurality of protruding portions 132.

The first electrode 141a may be an anode of the first light-emitting element 140a. The first electrode 141a may be electrically connected to the drain electrode 124 of the transistor 120 through the contact hole formed in the second overcoating layer 130. However, the first electrode 141a may be electrically connected to the source electrode 123 of the transistor 120 depending on the type of transistor 120, a method of designing the drive circuit, and the like.

FIG. 2 illustrates that the first electrode 141a is configured as a single layer. However, the first electrode 141a may be configured as a multilayer. For example, the first electrode 141a may include: a reflective layer configured to reflect the light emitted from the organic layer 142a toward the second electrode 143a; and a transparent conductive layer configured to supply holes to the organic layer 142a.

The reflective layer may be disposed on the overcoating layer 130 and reflect upward the light emitted from the first light-emitting element 140a. The light emitted from the organic layer 142a of the first light-emitting element 140a may not only propagate upward but also propagate laterally. The light emitted laterally may propagate into the display device 100 and be trapped in the display device 100 by being totally reflected. Further, the light may extinct after propagating into the display device 100. Therefore, the reflective layer may be disposed on a lower portion of the organic layer 142a and disposed to cover the first inclined surface SLO1. The reflective layer may change a propagation direction of the light propagating toward the lateral portion of the organic layer 142a to a forward direction.

The reflective layer may be made of a metallic material. For example, the reflective layer may be made of a metallic material such as aluminum (Al), silver (Ag), copper (Cu), or a magnesium-silver alloy (Mg:Ag). However, the present disclosure is not limited thereto.

The transparent conductive layer is disposed on the reflective layer. The transparent conductive layer may be made of an electrically conductive material with a high work function in order to supply the holes to the organic layer 142a. For example, the transparent conductive layer may be made of transparent conductive oxide based on indium tin oxide (ITO), indium zinc oxide (IZO), indium tin zinc oxide (ITZO), zinc oxide (ZnO), and tin oxide (TO). However, the present disclosure is not limited thereto.

The bank 150 is disposed on the overcoating layer 130 and the first electrode 141a. The bank 150 includes a top surface and a side surface. The top surface of the bank 150 is a surface positioned at an uppermost side of the bank 150. The top surface of the bank 150 may be a surface substantially parallel to the substrate 110. The side surface of the bank 150 may be a third inclined surface SLO3 that connects the top surface of the bank 150 and the first electrode 141a. The third inclined surface SLO3 may correspond to the first and second inclined surfaces SLO1 and SLO2. The third inclined surface SLO3 may have a shape inclined in a direction from the top surface toward the first electrode 141a.

The bank 150 may cover a part of the first electrode 141a and define an opening and a non-opening region. The opening may mean a first light-emitting area EA1 in which light is substantially produced by the organic layer 142a in each of the plurality of sub-pixels SP. The bank 150 is not disposed in the first light-emitting area EA1. The organic layer 142a may be positioned directly on the first electrode 141a and produce light. The non-opening region may mean a region in which the bank 150 is disposed and no light is produced. However, the non-opening region may include a second light-emitting area EA2 in which no light is produced. However, the second light-emitting area EA2 reflects the light so that the light is extracted forward. The second light-emitting area EA2 may be a light reflection area, i.e., an area corresponding to the first and second inclined surfaces SLO1 and SLO2. In the second light-emitting area EA2, the light emitted laterally from the first light-emitting element 140a may be extracted forward by the first electrode 141a disposed along the first inclined surface SLO1 of the protruding portion 132. In addition, the non-opening region may further include: a first non-light-emitting area NEA1 disposed between the first light-emitting area EA1 and the second light-emitting area EA2; and a second non-light-emitting area NEA2 disposed between the second light-emitting areas EA2 of the adjacent sub-pixels SP.

Meanwhile, the first electrode 141a may include a first region, a second region, and a third region in accordance with the first light-emitting area EA1, a first non-light-emitting area NEA1, the second light-emitting area EA2, and a second non-light-emitting area NEA2. For example, the first region of the first electrode 141a may be a flat region disposed on the base portion 131. The first region may correspond to the first light-emitting area EA1 and the first non-light-emitting area NEA1 and contribute to emitting light. The second region of the first electrode 141a may be a region corresponding to the first inclined surface SLO1 and include the second inclined surface SLO2. The second region may correspond to the second light-emitting area EA2 and contribute to light reflection. The first electrode 141a may have a side mirror shape defined by the second inclined surface SLO2 of the second region, thereby improving light extraction efficiency of the display device 100. The third region of the first electrode 141a may be a flat region disposed on the top surface of the protruding portion 132. The third region may correspond to the second non-light-emitting area NEA2. The first region, the second region, and the third region of the first electrode 141a may be deposited as a single component through the same process.

The bank 150 may be made of an organic material. For example, the bank 150 may be made of an organic material such as polyimide-based resin, acrylic-based resin, or benzocyclobutene-based resin. However, the present disclosure is not limited thereto. That is, the bank 150 may be made of an inorganic material.

The organic layer 142a is disposed on the first electrode 141a and the bank 150. For example, the organic layer 142a is disposed on the first electrode 141a in the first light-emitting area EA1 and disposed on the bank 150 in the non-opening region. Specifically, in the non-opening region, the organic layer 142a may be disposed on the third inclined surface SLO3 of the bank 150 and a part of the top surface of the bank 150. The organic layer 142a may be disposed along a shape of the first electrode 141a and a shape of the bank 150. The organic layer 142a may be patterned to correspond to each of the plurality of sub-pixels SP. The organic layer 142a may emit light with a particular color. Because the first sub-pixel SP1 in FIG. 2 is a red sub-pixel, the first light-emitting element 140a disposed in the first sub-pixel SP1 may be a red light-emitting element, and the organic layer 142a may include a red light-emitting layer that emits red light. In addition, the organic layer 142a may further include various layers such as a hole transport layer, a hole injection layer, a hole blocking layer, an electron injection layer, an electron blocking layer, and an electron transport layer.

The second electrode 143a is disposed on the organic layer 142a and the bank 150. The second electrode 143a may be disposed along a shape of the organic layer 142a. The second electrode 143a may be formed as a single common layer corresponding to all the plurality of sub-pixels SP. Since the second electrode 143a supplies the electrons to the organic layer 142a, the second electrode 143a may be made of an electrically conductive material with a low work function. The second electrode 143a may be a cathode of the first light-emitting element 140a. The second electrode 143a may be made of a transparent electrically conductive material such as indium tin oxide (ITO) and indium zinc oxide (IZO) or made of a metal alloy such as MgAg or a ytterbium (Yb) alloy. The second electrode 143a may further include a metal doping layer. However, the present disclosure is not limited thereto.

Meanwhile, although not illustrated in the drawings, a sealing part may be formed on the first light-emitting element 140a and protect the first light-emitting element 140a vulnerable to moisture so that the first light-emitting element 140a is not exposed to moisture. The sealing part may inhibit oxygen and moisture from permeating into the display device 100 from the outside. The sealing part may have a structure in which the inorganic layer and the organic layer are alternately stacked. However, the present disclosure is not limited thereto.

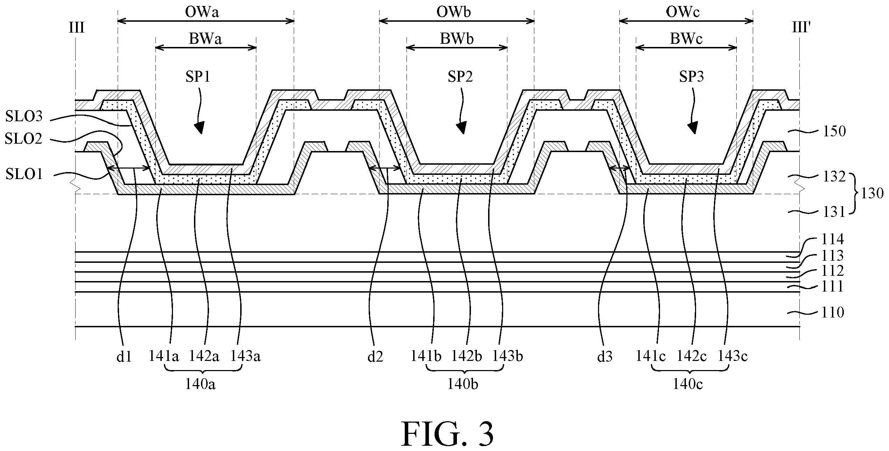

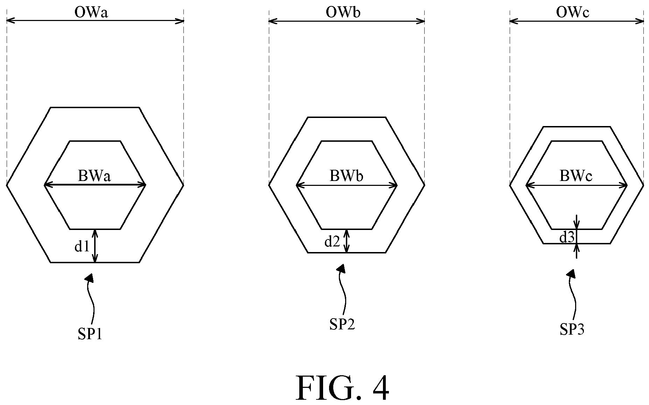

FIG. 3 is a cross-sectional view of the display device taken along line III-III' in FIG. 1. FIG. 4 is a schematic top plan view of FIG. 3. FIG. 4 briefly illustrates only the opening defined by the protruding portion 132 of each of the plurality of sub-pixels SP1, SP2, and SP3 and the opening defined by the bank 150. FIG. 4 illustrates that each of the openings have a hexagonal shape. However, the present disclosure is not limited thereto.

Referring to FIG. 3, the plurality of sub-pixels SP includes the first sub-pixel SP1, the second sub-pixel SP2, and the third sub-pixel SP3. The first sub-pixel SP1 is configured as a red sub-pixel, the second sub-pixel SP2 is configured as a green sub-pixel, and the third sub-pixel SP3 is configured as a blue sub-pixel. Each of the sub-pixels SP1, SP2, and SP3 have the same structure as the first sub-pixel SP1 illustrated in FIG. 2, except that the sub-pixels SP1, SP2, and SP3 emit light with different colors. Therefore, a repeated description will be omitted.

The first sub-pixel SP1 includes the first light-emitting element 140a that is the red light-emitting element. The first light-emitting element 140a may include the first electrode 141a, the organic layer 142a, and the second electrode 143a. In this case, the organic layer 142a may include a red light-emitting layer that emits red light.

The second sub-pixel SP2 includes a second light-emitting element 140b that is a green light-emitting element. The second light-emitting element 140b may include a first electrode 141b, an organic layer 142b, and a second electrode 143b. In this case, the organic layer 142b may include a green light-emitting layer that emits green light.

The third sub-pixel SP3 includes a third light-emitting element 140c that is a blue light-emitting element. The third light-emitting element 140c may include a first electrode 141c, an organic layer 142c, and a second electrode 143c. In this case, the organic layer 142c may include a blue light-emitting layer that emits blue light.

The display device 100 according to the exemplary example of the present disclosure is configured such that each of the light-emitting elements 140a, 140b, and 140c of the plurality of sub-pixels SP1, SP2, and SP3 include an anode having a side mirror shape. That is, the light trapped in the display device is extracted to the outside by each of the first electrodes 141a, 141b, and 141c having a side mirror shape. Therefore, it is possible to improve the light extraction efficiency and power consumption.

The first sub-pixel SP1, the second sub-pixel SP2, and the third sub-pixel SP3 are different from one another in terms of the distance between the side surface of the protruding portion 132 and the side surface of the bank 150. Specifically, a distance between the first inclined surface SLO1 and the third inclined surface SLO3 may vary for each of the plurality of sub-pixels SP1, SP2, and SP3. For example, in the first sub-pixel SP1, the first inclined surface SLO1 and the third inclined surface SLO3may be spaced apart from each other at a first distance d1. In the second sub-pixel SP2, the first inclined surface SLO1 and the third inclined surface SLO3may be spaced apart from each other at a second distance d2. In the third sub-pixel SP3, the first inclined surface SLO1 and the third inclined surface SLO3may be spaced apart from each other at a third distance d3.

In this case, each of the distances d1, d2, and d3 may be a distance in a first direction that is a direction parallel to the top surface of the substrate 110. In addition, each of the distances d1, d2, and d3 may mean a sum of a width of the bank 150 and a width of each of the first electrodes 141a, 141b, and 141c that each correspond to the side surface of the protruding portion 132. That is, each of the distances d1, d2, and d3 may be a value made by summing up a width of the inclined region of each of the first electrodes 141a, 141b, and 141c disposed on the side surface of the protruding portion 132 and a width of the inclined region of the bank 150 that covers the inclined region of each of the first electrodes 141a, 141b, and 141c. Because the first electrodes 141a, 141b, and 141c may have similar thicknesses and widths in the plurality of sub-pixels SP1, SP2, and SP3, the width of the inclined region of the bank 150 may vary for each of the plurality of sub-pixels SP1, SP2, and SP3. In this case, each of the widths of the first electrodes 141a, 141b, and 141c and the width of the bank 150 may be a width in the first direction.

The first distance d1 may be larger than the second distance d2 and the third distance d3. In addition, the second distance d2 may be larger than the third distance d3. That is, among the first distance d1, the second distance d2, and the third distance d3, the first distance d1 is the longest, and the third distance d3 is the shortest. In addition, the width of the inclined region of the bank 150 in the first sub-pixel SP1 is the largest, and the width of the inclined region of the bank 150 in the third sub-pixel SP3 is the smallest. In this case, the first distance d1 may be 2.5 µm or more. In addition, the second distance d2 may be 1.5 µm to 2.5 µm. In addition, the third distance d3 may be 1 µm to 2 µm.

Because the distances d1, d2, and d3 in the first sub-pixel SP1, the second sub-pixel SP2, and the third sub-pixel SP3 are designed to be different from one another, it is possible to improve a brightness viewing angle and a color viewing angle of each of the sub-pixels SP1, SP2, and SP3. In this case, the brightness viewing angle means a brightness deviation with respect to a change in viewing angle, and the color viewing angle means a change in color with respect to a change in viewing angle. Therefore, when the brightness viewing angle is improved, the brightness deviation may be minimized, and the lateral visibility may be improved even though the viewing angle changes. In particular, because the distances d1, d2, and d3 in the sub-pixels SP1, SP2, and SP3 are designed to be different from one another, it is possible to improve the color viewing angle and minimize a color shift that occurs in accordance with a viewing angle.

Meanwhile, referring to FIGS. 3 and 4, a width BWa of the opening defined by the bank 150 in the first sub-pixel SP1, a width BWb of the opening defined by the bank 150 in the second sub-pixel SP2, and a width BWc of the opening defined by the bank 150 in the third sub-pixel SP3 may be equal to one another. In this case, the opening defined by the bank 150 may correspond to the first light-emitting area EA1 of each of the sub-pixels SP1. That is, all the widths BWa, BWb, and BWc in the first light-emitting areas EA1 of the plurality of sub-pixels SP1, SP2, and SP3 may be equal to one another. In this case, the widths OWa, OWb, and OWc of the concave portions of the overcoating layers 130 in the plurality of sub-pixels SP1, SP2, and SP3 may be different from one another. That is, the width OWa of the concave portion of the first sub-pixel SP1 is larger than the width OWb of the concave portion of the second sub-pixel SP2. The width OWb of the concave portion of the second sub-pixel SP2 is larger than the width OWc of the concave portion of the third sub-pixel SP3.

However, all the widths OWa, OWb, and OWc of the concave portions of the plurality of sub-pixels SP1, SP2, and SP3 may be equal to one another, and the widths BWa, BWb, and BWc of the first light-emitting areas EA1 of the plurality of sub-pixels SP1, SP2, and SP3 may be different from one another. In this case, the width BWa of the first light-emitting area EA1 of the first sub-pixel SP1 is smaller than the width BWb of the first light-emitting area EA1 of the second sub-pixel SP2. The width BWb of the first light-emitting area EA1 of the second sub-pixel SP2 is smaller than the width BWc of the first light-emitting area EA1 of the third sub-pixel SP3.

As a value made by dividing each of the widths BWa, BWb, and BWc of the first light-emitting areas EA1 by each of the widths OWa, OWb, and OWc of the concave portions increases, the distance between the first light-emitting area EA1 and the second light-emitting area EA2 decreases, and the width of the first non-light-emitting area NEA1 decreases. In addition, as a value made by subtracting each of the widths BWa, BWb, and BWc of the first light-emitting areas EA1 from each of the widths OWa, OWb, and OWc of the concave portions decreases, the distance between the first light-emitting area EA1 and the second light-emitting area EA2 decreases, and the width of the first non-light-emitting area NEA1 decreases.

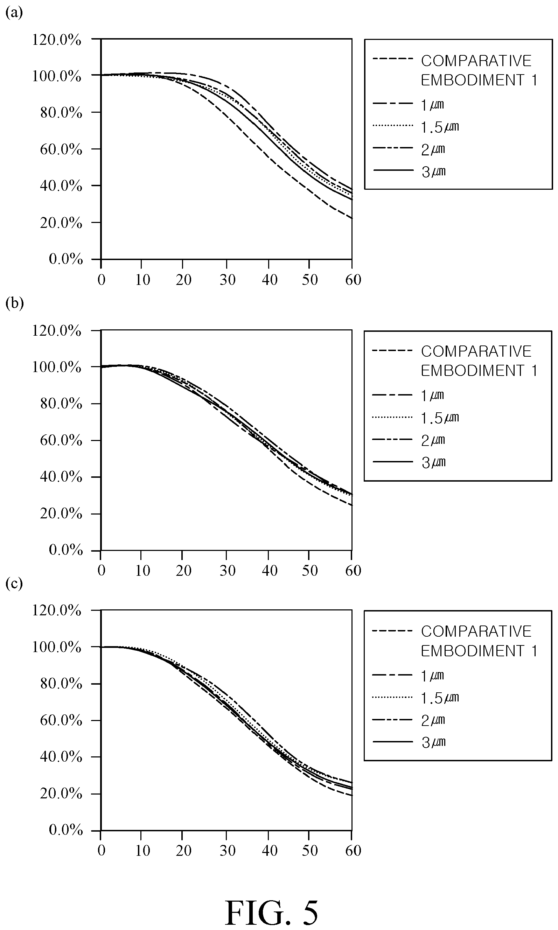

FIG. 5 is a graph illustrating a change in brightness with respect to a viewing angle. Specifically, FIG. 5A is a view illustrating a change in brightness with respect to a viewing angle in the red sub-pixel, FIG. 5B is a view illustrating a change in brightness with respect to a viewing angle in the green sub-pixel, and FIG. 5C is a view illustrating a change in brightness with respect to a viewing angle in the blue sub-pixel. In this case, the light-emitting element of the red sub-pixel has a maximum wavelength of 624 nm and a half-width of 26 nm. The light-emitting element of the green sub-pixel has a maximum wavelength of 532 nm and a half-width of 25 nm. The light-emitting element of the blue sub-pixel has a maximum wavelength of 464 nm and a half-width of 16 nm.

Comparative Example 1 refers to a case in which none of the red sub-pixel, the green sub-pixel, and the blue sub-pixel include the anode having the side mirror shape. That is, in Comparative Example 1, an overcoating layer of a sub-pixel has only a base portion without including a protruding portion, and an anode has only a flat region without including an inclined region. Each of 1 µm, 1.5 µm, 2 µm, and 3 µm are a distance between the first inclined surface, which is the side surface of the protruding portion, and the third inclined surface, which is the side surface of the bank, in the sub-pixel including the anode having the side mirror shape. Hereinafter, for the convenience of description, the distance between the first inclined surface and the third inclined surface will be referred to as a "distance".

Referring to FIG. 5, when the anode having the side mirror shape is included, the brightness viewing angles are improved in all the sub-pixels in comparison with a case in which the anode having the side mirror shape is not included. However, the distance, which shows excellent properties of the brightness viewing angle, varies for each of the sub-pixels. For example, the best properties of the brightness viewing angle are implemented when the distance is 1 µm in the red sub-pixel, the best properties of the brightness viewing angle are implemented when the distance is 2 µm in the green sub-pixel, and the best properties of the brightness viewing angle are implemented when the distance is 2 µm in the blue sub-pixel. In addition, a brightness value with respect to the viewing angle varies for each of the sub-pixels and for each of the distances. For example, based on a viewing angle of 30°, a brightness value of the red sub-pixel in which the distance is 1 µm, a brightness value of the green sub-pixel in which the distance is 2 µm, and a brightness value of the blue sub-pixel in which the distance is 2 µm are different from one another. If a brightness value of any one sub-pixel is relatively larger or smaller than the brightness values of the other sub-pixels, there may occur a problem in that the color shift occurs, and the color changes depending on the viewing angle. For example, when the brightness value of the red sub-pixel relatively increases, the independent brightness viewing angle of the red sub-pixel itself may be improved. However, the color shift occurs when the plurality of sub-pixels collectively emits light, which may cause a deterioration in the overall color viewing angle.

In the display device 100 according to the exemplary example of the present disclosure, the first distance d1 in the first sub-pixel SP1 may be larger than the second distance d2 in the second sub-pixel SP2 and the third distance d3 in the third sub-pixel SP3. In addition, the second distance d2 in the second sub-pixel SP2 may be larger than the third distance d3 in the third sub-pixel SP3. Therefore, it is possible to improve the brightness viewing angle of the display device 100 and minimize the occurrence of the color shift. Specifically, the brightness values with respect to the viewing angles of the sub-pixels SP1, SP2, and SP3 may be similar to one another when the first distance d1 is the longest and the third distance d3 is the shortest among the first distance d1, the second distance d2, and the third distance d3. Therefore, the change in color with respect to the viewing angle is minimized, which makes it possible to improve the color viewing angle. Therefore, both the brightness viewing angle and the color viewing angle are improved, which makes it possible to improve the display quality of the display device 100.

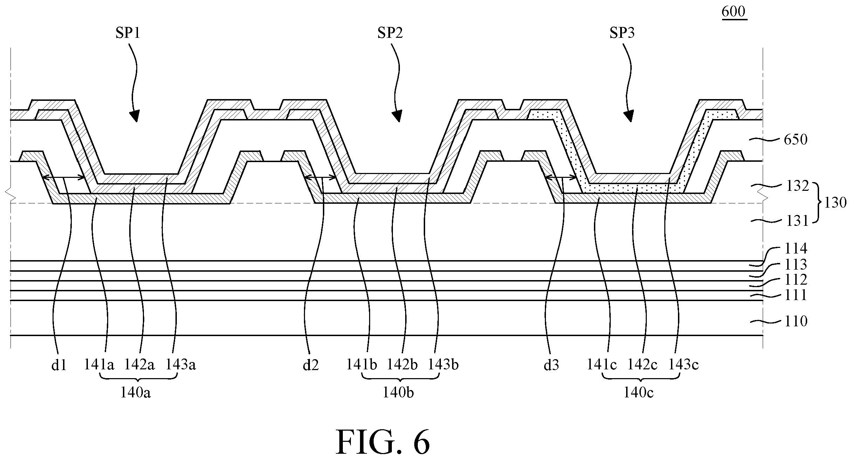

FIG. 6 is a cross-sectional view of a display device according to another exemplary example of the present disclosure. The display device 600 illustrated in FIG. 6 is substantially identical to the display device 100 illustrated in FIGS. 1 to 4, except for a distance between the side surface of the protruding portion 132 and the side surface of the bank 650. Therefore, a repeated description will be omitted.

Referring to FIG. 6, the display device 600 includes: a first sub-pixel SP1 including the first light-emitting element 140a configured to emit red light; a second sub-pixel SP2 including the second light-emitting element 140b configured to emit green light; and a third sub-pixel SP3 including the third light-emitting element 140c configured to emit blue light.

The first sub-pixel SP1, the second sub-pixel SP2, and the third sub-pixel SP3 are different from one another in terms of the distance between the side surface of the overcoating layer 130 and a side surface of a bank 650. Specifically, a distance between the side surface of the protruding portion 132 and the side surface of the bank 650 may vary for each of the plurality of sub-pixels SP1, SP2, and SP3. For example, in the first sub-pixel SP1, the side surface of the protruding portion 132 and the side surface of the bank 650 may be spaced apart from each other at the first distance d1. In the second sub-pixel SP2, the side surface of the protruding portion 132 and the side surface of the bank 650 may be spaced apart from each other at the second distance d2. In the third sub-pixel SP3, the side surface of the protruding portion 132 and the side surface of the bank 650 may be spaced apart from each other at the third distance d3.

The first distance d1 may be larger than the second distance d2 and the third distance d3. In addition, the second distance d2 may be equal to the third distance d3. That is, among the first distance d1, the second distance d2, and the third distance d3, the first distance d1 may be the longest, and the second and third distances d2 and d3 may be equal to each other. Therefore, the width of the inclined region of the bank 650 in the first sub-pixel SP1 is the largest. The width of the inclined region of the bank 650 in the second sub-pixel SP2 is equal to the width of the inclined region of the bank 650 in the third sub-pixel SP3. In this case, the first distance d1 may be 2.5 µm or more. In addition, the second distance d2 may be 1.5 µm to 2.5 µm. In addition, the third distance d3 may be 1 µm to 2 µm.

The display device 600 according to another exemplary example of the present disclosure may improve both the brightness viewing angle and the color viewing angle by appropriately adjusting the first distance d1, the second distance d2, and the third distance d3. Specifically, each of the first electrodes 141a, 141b, and 141c, having the side mirror shape, may improve the light extraction efficiency and reduce a brightness deviation according to the viewing angle. In addition, the brightness values with respect to the viewing angles of the sub-pixels SP1, SP2, and SP3 may be similar to one another when the first distance d1 is the longest and the second and third distances d2 and d3 are equal to each other among the first distance d1, the second distance d2, and the third distance d3. Therefore, the change in color with respect to the viewing angle is minimized, which makes it possible to improve the color viewing angle. Therefore, both the brightness viewing angle and the color viewing angle are improved, which makes it possible to improve the display quality of the display device 600.

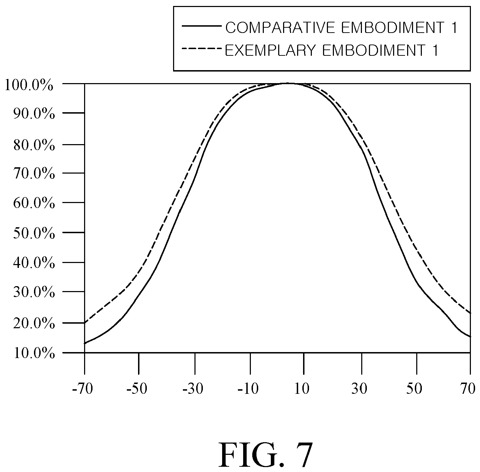

FIG. 7 is a graph illustrating a change in brightness with respect to a viewing angle. Comparative Example 1 illustrated in FIG. 7 is equal to Comparative Example 1 illustrated in FIG. 5. In Exemplary Example 1 in FIG. 7, the distance between the side surface of the protruding portion of the red sub-pixel and the side surface of the bank is 3 µm, the distance between the side surface of the protruding portion of the green sub-pixel and the side surface of the bank is 2 µm, and the distance between the side surface of the protruding portion of the blue sub-pixel and the side surface of the bank is 1.5 µm. The maximum wavelengths and the half-widths of the light-emitting elements of the sub-pixels are respectively set to be equal to those set as illustrated in FIG. 5.

Table 1 shows brightness and degrees of color shift with respect to viewing angles in Comparative Example 1 and Exemplary Example 1. In this case, the color shift is expressed as JND values, and JND refers to a numerical value indicating a change in color. Specifically, as the JND value increases, a user may more clearly recognize a change in color.

**[Table 1]**

| | Viewing angle | Comparative Example 1 | Exemplary Example 1 |
|---|---|---|---|
| Brightness | 30° | 78.5% (471 nit) | 82.6% (496 nit) |
| | 45° | 45.4% (272 nit) | 53.2% (319 nit) |
| | 60° | 22.4% (134 nit) | 30.8% (185 nit) |
| JND (Δu' v' ) | 30° | 4.5 (0.007) | 4.4 (0.006) |
| | 45° | 6.7 (0.009) | 0.9 (0.001) |
| | 60° | 12.1 (0.012) | 8.5 (0.013) |

Referring to FIG. 7 and Table 1, it can be seen that the brightness of Exemplary Example 1 is improved at viewing angles of 30°, 45°, and 60° in comparison with Comparative Example 1. Specifically, at the viewing angles of 30°, 45°, and 60°, the brightness of Exemplary Example 1 has values increased by about 5.3%, 17.3%, and 38.1% in comparison with the brightness of Comparative Example 1. Therefore, in Exemplary Example 1, a deviation between the brightness on the front surface and the brightness on the side surface may be reduced. That is, in Exemplary Example 1, the brightness viewing angle is improved, which makes it possible to improve lateral visibility. In addition, referring to Table 1, it can be seen that at the viewing angles of 30°, 45°, and 60°, the JND values are reduced in Exemplary Example 1 in comparison with Comparative Example 1. In particular, in Exemplary Example 1, the JND values are significantly reduced at the viewing angles of 45° and 60°. Therefore, in Exemplary Example 1, a difference between a color recognized on the front surface and a color recognized on the side surface may be reduced. That is, in Exemplary Example 1, the color viewing angle is improved, which makes it possible to improve display quality.

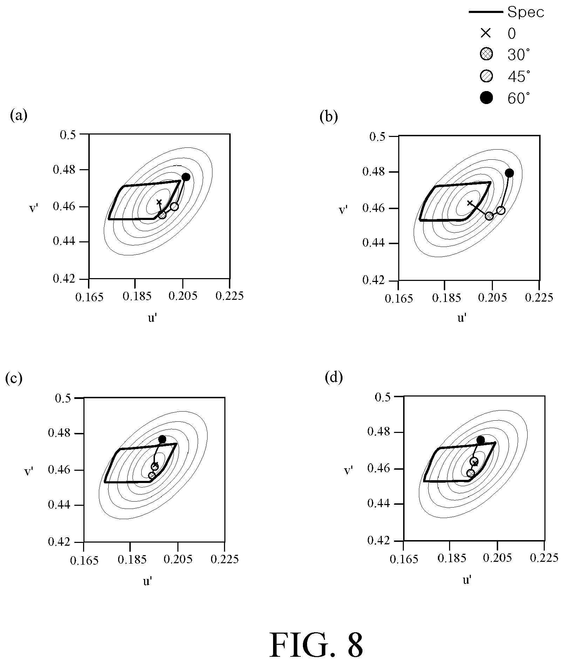

FIG. 8 is a graph illustrating a color shift with respect to a viewing angle. Specifically, FIG. 8A is a view illustrating a color shift with respect to a viewing angle in Comparative Example 2, FIG. 8B is a view illustrating a color shift with respect to a viewing angle in Comparative Example 3, FIG. 8C is a view illustrating a color shift with respect to a viewing angle in Exemplary Example 1, and FIG. 8D is a view illustrating a color shift with respect to a viewing angle in Exemplary Example 2. FIG. 8 illustrates a color coordinate. Although not illustrated in the drawings, a left upper portion means green, a right upper portion means yellow, a right lower portion means red, and a left lower portion means blue. Line Spec indicates an optimal condition, and it can be determined that a change in color becomes severer as the distance from line Spec increases. For example, when the distance from line Spec exceeds 70%, the user may more clearly recognize the change in color and determine this situation as a defect.

In Comparative Example 2, the distances between the side surfaces of the protruding portions and the side surfaces of the banks of the red sub-pixel, the green sub-pixel, and the blue sub-pixel are equally set to 1.5 µm. In Comparative Example 3, the distances between the side surfaces of the protruding portions and the side surfaces of the banks of the red sub-pixel and the green sub-pixel are equally set to 1 µm, and the distance between the side surface of the protruding portion and the side surface of the bank of the blue sub-pixel is set to 3 µm. Exemplary Example 1 is identical to Exemplary Example 1 illustrated in FIG. 7. In Exemplary Example 2, the distance between the side surface of the protruding portion of the red sub-pixel and the side surface of the bank is 3 µm, the distance between the side surface of the protruding portion of the green sub-pixel and the side surface of the bank is 2 µm, and the distance between the side surface of the protruding portion of the blue sub-pixel and the side surface of the bank is 2 µm. The maximum wavelengths and the half-widths of the light-emitting elements of the sub-pixels are respectively set to be equal to those set as illustrated in FIG. 5.

Referring to FIG. 8, in Comparative Examples 2 and 3, the color shift occurs while exceeding line Spec at all the viewing angles of 30°, 45°, and 60°. That is, it can be seen that the color shift occurs to the extent that the user clearly recognizes the color shift when the distances between the side surfaces of the protruding portions and the side surfaces of the banks in the red, green, and blue sub-pixels are equally set, like Comparative Example 2. In addition, it can be seen that the color shift occurs to the extent that the user clearly recognizes the color shift when the distance between the side surface of the protruding portion and the side surface of the bank in the blue sub-pixel is the longest among the red, green, and blue sub-pixels, like Comparative Example 3. In Exemplary Examples 1 and 2, the color shift is minimized in comparison with Comparative Examples 2 and 3. In particular, because the degree of the color shift does not exceed line Spec, the user cannot recognize the change in color with respect to the viewing angle, or the user may finely recognize the change in color. Therefore, when the first distance in the red sub-pixel is the longest and the third distance in the blue sub-pixel is the shortest among the red, green, and blue sub-pixels, the color shift with respect to the viewing angle may be minimized, and the color viewing angle may be improved. Alternatively, when the first distance in the red sub-pixel is the longest and the second and third distances in the green and blue sub-pixels are equal to each other among the red, green, and blue sub-pixels, the color shift with respect to the viewing angle may be minimized, and the color viewing angle may be improved.

The exemplary examples of the present disclosure can also be described as follows:

According to an aspect of the present disclosure, a display device includes: a substrate including a plurality of sub-pixels; an overcoating layer on the substrate and including a base portion and a protruding portion; a first electrode covering the base portion and the protruding portion; a bank on a part of the first electrode; an organic layer on the first electrode and the bank; and a second electrode on the organic layer, in which a distance between a side surface of the protruding portion and a side surface of the bank varies for each of the plurality of sub-pixels.

The plurality of sub-pixels may include a first sub-pixel, a second sub-pixel, and a third sub-pixel, the side surface of the protruding portion and the side surface of the bank of the first sub-pixel may be spaced apart from each other at a first distance, the side surface of the protruding portion and the side surface of the bank of the second sub-pixel may be spaced apart from each other at a second distance, and the side surface of the protruding portion and the side surface of the bank of the third sub-pixel may be spaced apart from each other at a third distance.

The first distance may be greater than the second distance and the third distance.

The second distance may be greater than the third distance.

The second distance may be equal to the third distance.

The first distance may be 2.5 µm or more.

The second distance may be 1.5 µm to 2.5 µm.

The third distance may be 1 µm to 2 µm.

The first sub-pixel may be a red sub-pixel, the second sub-pixel may be a green sub-pixel, and the third sub-pixel may be a blue sub-pixel.

The distance may be a distance in a direction parallel to a top surface of the substrate.

According to another aspect of the present disclosure, a display device includes: a substrate including a plurality of sub-pixels; an overcoating layer on the substrate and including a base portion and a protruding portion; a first electrode covering the base portion and the protruding portion; a bank on a part of the first electrode; an organic layer on the first electrode and the bank; and a second electrode on the organic layer, in which a width of the bank corresponding to a side surface of the protruding portion varies for each of the plurality of sub-pixels.

The plurality of sub-pixels may include a red sub-pixel, a green sub-pixel, and a blue sub-pixel, and the width of the bank corresponding to the side surface of the protruding portion may be the greatest in the red sub-pixel.

The the plurality of sub-pixels may include a red sub-pixel, a green sub-pixel, and a blue sub-pixel, and the width of the bank corresponding to the side surface of the protruding portion may be the smallest in the blue sub-pixel.

The plurality of sub-pixels may include a red sub-pixel, a green sub-pixel, and a blue sub-pixel, and the width of the bank corresponding to the side surface of the protruding portion in the green sub-pixel may be equal to the width of the bank corresponding to the side surface of the protruding portion in the blue sub-pixel.

The width of the bank may be a distance in a direction parallel to a top surface of the substrate.

According to yet another aspect of the present disclosure, a display device includes: a substrate including a plurality of sub-pixels; an overcoating layer on the substrate and having a concave portion; a first electrode covering the concave portion; a bank configured to expose a part of the first electrode through an opening; an organic layer on the first electrode; and a second electrode on the organic layer, in which in each of at least two sub-pixels, among the plurality of sub-pixels, a value obtained by subtracting a width of the opening from a width of the concave portion is different from each other.

The concave portion may include an inclined surface. Each of the the plurality of sub-pixels may include: a first light-emitting area corresponding to the opening; and a second light-emitting area corresponding to the inclined surface.

At least two sub-pixels, among the plurality of sub-pixels, may have different distances between the first light-emitting area and the second light-emitting area.

According to yet another aspect of the present disclosure, a display device includes : an overcoating layer on a substrate; and a plurality of light emitting elements disposed on the overcoating layer, each of the light emitting elements including a first electrode, an organic layer on the first electrode, and a second electrode on the organic layer, in which the first electrode includes a first portion, a second portion that is on a first side of the first portion and inclined with respect to the first portion, and a third portion that is on a second side of the first portion and inclined with respect to the first portion; in which the organic layer includes a first part, a second part that is on a first side of the first part and inclined with respect to the first part, and a third part that is on a second side of the first part and inclined with respect to the first part, the first part of the organic layer having a smaller width than the first portion of the first electrode by a distance that is different among the plurality of light emitting elements; and in which the second electrode includes a first section, a second section that is on a first side of the first section and inclined with respect to the first section, and a third section that is on a second side of the first section and inclined with respect to the first section.

The plurality of light emitting elements may include a first light emitting element, a second light emitting element, and a third light emitting element. The distance in the first light emitting element may be greater than the distance in the second light emitting element and the third light emitting element.

The distance in the second light emitting element may be equal to or greater than the distance in the third light emitting element.

The first light emitting element may emit red light, the second light emitting element may emit green light, and the third light emitting element may emit blue light.

Each of the light emitting elements may further include banks disposed between the second portion of the first electrode and the second and third parts of the organic layer, at least parts of the banks may be inclined with respect to the first portion of the first electrode.
Further examples are set out in the clauses below:
1. A display device comprising: a substrate including a plurality of sub-pixels; an overcoating layer on the substrate and including a base portion and a protruding portion; a first electrode covering the base portion and the protruding portion; a bank on a part of the first electrode; an organic layer on the first electrode and the bank; and a second electrode on the organic layer, wherein a distance between a side surface of the protruding portion and a side surface of the bank varies for each of the plurality of sub-pixels.
2. The display device of clause 1, wherein the plurality of sub-pixels include a first sub-pixel, a second sub-pixel, and a third sub-pixel, wherein the side surface of the protruding portion and the side surface of the bank of the first sub-pixel are spaced apart from each other at a first distance, the side surface of the protruding portion and the side surface of the bank of the second sub-pixel are spaced apart from each other at a second distance, and the side surface of the protruding portion and the side surface of the bank of the third sub-pixel are spaced apart from each other at a third distance.
3. The display device of clause 2, wherein the first distance is greater than the second distance and the third distance.
4. The display device of clause 3, wherein the second distance is greater than the third distance.
5. The display device of clause 3, wherein the second distance is equal to the third distance.
6. The display device of clause 2, wherein the first distance is 2.5 µm or more.
7. The display device of clause 3, wherein the second distance is 1.5 µm to 2.5 µm.
8. The display device of clause 3, wherein the third distance is 1 µm to 2 µm.
9. The display device of clause 2, wherein the first sub-pixel is a red sub-pixel, the second sub-pixel is a green sub-pixel, and the third sub-pixel is a blue sub-pixel.
10. The display device of clause 1, wherein the distance is a distance in a direction parallel to a top surface of the substrate.
11. A display device comprising: a substrate including a plurality of sub-pixels; an overcoating layer on the substrate and including a base portion and a protruding portion; a first electrode covering the base portion and the protruding portion; a bank on a part of the first electrode; an organic layer on the first electrode and the bank; and a second electrode on the organic layer,wherein a width of the bank corresponding to a side surface of the protruding portion varies for each of the plurality of sub-pixels.
12. The display device of clause 11, wherein the plurality of sub-pixels include a red sub-pixel, a green sub-pixel, and a blue sub-pixel, and wherein the width of the bank corresponding to the side surface of the protruding portion is the greatest in the red sub-pixel.
13. The display device of clause 12, wherein the plurality of sub-pixels include a red sub-pixel, a green sub-pixel, and a blue sub-pixel, and wherein the width of the bank corresponding to the side surface of the protruding portion is the smallest in the blue sub-pixel.
14. The display device of clause 12, wherein the plurality of sub-pixels include a red sub-pixel, a green sub-pixel, and a blue sub-pixel, and wherein the width of the bank corresponding to the side surface of the protruding portion in the green sub-pixel is equal to the width of the bank corresponding to the side surface of the protruding portion in the blue sub-pixel.
15. The display device of clause 11, wherein the width of the bank is a distance in a direction parallel to a top surface of the substrate.
16. A display device comprising: a substrate including a plurality of sub-pixels; an overcoating layer on the substrate and having a concave portion; a first electrode covering the concave portion; a bank configured to expose a part of the first electrode through an opening; an organic layer on the first electrode; and a second electrode on the organic layer,
   wherein in each of at least two sub-pixels, among the plurality of sub-pixels, a value obtained by subtracting a width of the opening from a width of the concave portion is different from each other.
17. The display device of clause 16, wherein the concave portion includes an inclined surface, and wherein each of the plurality of sub-pixels includes: a first light-emitting area corresponding to the opening; and a second light-emitting area corresponding to the inclined surface.
18. The display device of clause 17, wherein at least two sub-pixels, among the plurality of sub-pixels, have different distances between the first light-emitting area and the second light-emitting area.
19. A display device comprising: an overcoating layer on a substrate; and a plurality of light emitting elements disposed on the overcoating layer, each of the light emitting elements including a first electrode, an organic layer on the first electrode, and a second electrode on the organic layer, wherein the first electrode includes a first portion, a second portion that is on a first side of the first portion and inclined with respect to the first portion, and a third portion that is on a second side of the first portion and inclined with respect to the first portion; wherein the organic layer includes a first part, a second part that is on a first side of the first part and inclined with respect to the first part, and a third part that is on a second side of the first part and inclined with respect to the first part, the first part of the organic layer having a smaller width than the first portion of the first electrode by a distance that is different among the plurality of light emitting elements; and wherein the second electrode includes a first section, a second section that is on a first side of the first section and inclined with respect to the first section, and a third section that is on a second side of the first section and inclined with respect to the first section.
20. The display device of clause 19, wherein the plurality of light emitting elements include a first light emitting element, a second light emitting element, and a third light emitting element, and wherein the distance in the first light emitting element is greater than the distance in the second light emitting element and the third light emitting element.
21. The display device of clause 20, wherein the distance in the second light emitting element is equal to or greater than the distance in the third light emitting element.
22. The display device of clause 19, wherein the first light emitting element emits red light, the second light emitting element emits green light, and the third light emitting element emits blue light.
23. The display device of clause 19, wherein each of the light emitting elements further includes banks disposed between the second portion of the first electrode and the second and third parts of the organic layer, at least parts of the banks inclined with respect to the first portion of the first electrode.

Although the exemplary examples of the present disclosure have been described in detail with reference to the accompanying drawings, the present disclosure is not limited thereto and may be embodied in many different forms without departing from the technical concept of the present disclosure. Therefore, the exemplary examples of the present disclosure are provided for illustrative purposes only but not intended to limit the technical concept of the present disclosure. The scope of the technical concept of the present disclosure is not limited thereto. Therefore, it should be understood that the above-described exemplary examples are illustrative in all aspects and do not limit the present disclosure.

## Claims

1. A display device comprising:
a substrate including a plurality of sub-pixels;
an overcoating layer on the substrate and including a base portion and a protruding portion;
a first electrode covering the base portion and the protruding portion;
a bank on a part of the first electrode;
an organic layer on the first electrode and the bank; and
a second electrode on the organic layer,
wherein a distance between a side surface of the protruding portion and a side surface of the bank varies for each of the plurality of sub-pixels.

2. The display device of claim 1, wherein the plurality of sub-pixels include a first sub-pixel, a second sub-pixel, and a third sub-pixel,
wherein the side surface of the protruding portion and the side surface of the bank of the first sub-pixel are spaced apart from each other at a first distance, the side surface of the protruding portion and the side surface of the bank of the second sub-pixel are spaced apart from each other at a second distance, and the side surface of the protruding portion and the side surface of the bank of the third sub-pixel are spaced apart from each other at a third distance.

3. The display device of claim 2, wherein the first distance is greater than the second distance and the third distance.

4. The display device of claim 2 or claim 3, wherein the second distance is greater than the third distance.

5. The display device of claim 2 or claim 3, wherein the second distance is equal to the third distance.

6. The display device of claim 2, wherein the first distance is 2.5 µm or more; and optionally
wherein the second distance is 1.5 µm to 2.5 µm; or optionally
wherein the third distance is 1 µm to 2 µm.

7. The display device of any one of claims 2-6, wherein the first sub-pixel is a red sub-pixel, the second sub-pixel is a green sub-pixel, and the third sub-pixel is a blue sub-pixel.

8. The display device of any one of the preceding claims, wherein the distance is a distance in a direction parallel to a top surface of the substrate.

9. A display device comprising:
a substrate including a plurality of sub-pixels;
an overcoating layer on the substrate and including a base portion and a protruding portion;
a first electrode covering the base portion and the protruding portion;
a bank on a part of the first electrode;
an organic layer on the first electrode and the bank; and
a second electrode on the organic layer,
wherein a width of the bank corresponding to a side surface of the protruding portion varies for each of the plurality of sub-pixels.

10. The display device of claim 9, wherein the plurality of sub-pixels include a red sub-pixel, a green sub-pixel, and a blue sub-pixel, and
wherein the width of the bank corresponding to the side surface of the protruding portion is the greatest in the red sub-pixel; or optionally
wherein the plurality of sub-pixels include a red sub-pixel, a green sub-pixel, and a blue sub-pixel, and
wherein the width of the bank corresponding to the side surface of the protruding portion is the smallest in the blue sub-pixel.

11. The display device of claim 10, wherein the plurality of sub-pixels include a red sub-pixel, a green sub-pixel, and a blue sub-pixel, and
wherein the width of the bank corresponding to the side surface of the protruding portion in the green sub-pixel is equal to the width of the bank corresponding to the side surface of the protruding portion in the blue sub-pixel.

12. The display device of claim 9, wherein the width of the bank is a distance in a direction parallel to a top surface of the substrate.

13. A display device comprising:
a substrate including a plurality of sub-pixels;
an overcoating layer on the substrate and having a concave portion;
a first electrode covering the concave portion;
a bank configured to expose a part of the first electrode through an opening;
an organic layer on the first electrode; and
a second electrode on the organic layer,
wherein in each of at least two sub-pixels, among the plurality of sub-pixels, a value obtained by subtracting a width of the opening from a width of the concave portion is different from each other.

14. The display device of claim 13, wherein the concave portion includes an inclined surface, and
wherein each of the plurality of sub-pixels includes:
a first light-emitting area corresponding to the opening; and
a second light-emitting area corresponding to the inclined surface.

15. The display device of claim 14, wherein at least two sub-pixels, among the plurality of sub-pixels, have different distances between the first light-emitting area and the second light-emitting area.
